# EUROPEAN PATENT APPLICATION

(11) **EP 4 539 625 A1**
(43) Date of publication of application: **16.04.2025**
(21) Application number: 23819080.5
(22) Date of filing: 05.06.2023
(51) Int. Cl.: H05K 9/00

(54) **ELECTROMAGNETIC SHIELDING STRUCTURE, CHIP STRUCTURE, ELECTRONIC DEVICE AND VEHICLE**

(30) Priority: 06.06.2022 CN 202210635054
(71) Applicant: Shenzhen Yinwang Intelligent Technologies Co., Ltd., Shenzhen, Guangdong 518129 (CN)
(72) Inventor: MA, Xuewen, Shenzhen, Guangdong 518129 (CN); WU, Zeliang, Shenzhen, Guangdong 518129 (CN); XU, Qiaoyang, Shenzhen, Guangdong 518129 (CN); HUANG, Bolin, Shenzhen, Guangdong 518129 (CN); XIE, Zhengsheng, Shenzhen, Guangdong 518129 (CN); HUANG, Rui, Shenzhen, Guangdong 518129 (CN)
(74) Representative: Pfenning, Meinig & Partner mbB
(86) International application number: PCT/CN2023/098397
(87) International publication number: WO 2023/236915

(57) **Abstract**

Embodiments of this application provide an electromagnetic shielding structure, a chip structure, an electronic device, and a vehicle, which may be used in the fields such as autonomous driving, artificial intelligence, voice processing, and image processing. The electromagnetic shielding structure includes: a metal cover that includes a side wall and a top plate, where the top plate includes an opening, a bottom of the side wall is fastened to a printed circuit board, and the side wall are configured to surround a chip on the printed circuit board; and a heat dissipation mechanical component that includes a mechanical component enclosure and a structural boss, where the structural boss protrudes from the mechanical component enclosure, and the structural boss is configured to contact the chip through the opening in the top plate. The solutions of this application can implement heat dissipation and electromagnetic shielding for the chip.

## Description

This application claims priority to Chinese Patent Application No. 202210635054.X, filed with the China National Intellectual Property Administration on June 6, 2022 and entitled "ELECTROMAGNETIC SHIELDING STRUCTURE, CHIP STRUCTURE, ELECTRONIC DEVICE, AND VEHICLE", which is incorporated herein by reference in its entirety.

### TECHNICAL FIELD

Embodiments of this application relate to the field of semiconductor technologies, and more specifically, to an electromagnetic shielding structure, a chip structure, an electronic device, and a vehicle.

### BACKGROUND

With continuous development of technologies, electromagnetic interference is ubiquitous between devices such as communication devices, computers, mobile phones, and automobiles, and inside the devices. If these interference signals cannot be effectively eliminated, these interference signals enter chips of these devices, to interfere with large-scale integrated circuits, causing the circuits to fail to work normally or work in an abnormal status.

In a conventional technology, a metal cover is usually disposed on a chip to shield an electromagnetic signal, to avoid electromagnetic interference to the chip. However, an enclosed cavity of the metal cover hinders rapid heat dissipation in the chip. In addition, with improvement of computing power, a rate and power consumption of the chip are continuously increased, resulting in a significant increase in heat generation. This seriously affects application performance of the chip.

Therefore, how to implement heat dissipation and electromagnetic shielding for the chip is a technical problem to be urgently resolved.

### SUMMARY

Embodiments of this application provide an electromagnetic shielding structure, a chip structure, an electronic device, and a vehicle. The electromagnetic shielding structure can implement heat dissipation and electromagnetic shielding for a chip.

According to a first aspect, an electromagnetic shielding structure is provided. The electromagnetic shielding structure includes: a metal cover that includes a side wall and a top plate, where the top plate includes an opening, a bottom of the side wall is fastened to a printed circuit board, and the side wall are configured to surround a chip on the printed circuit board; and a heat dissipation mechanical component that includes a mechanical component enclosure and a structural boss, where the structural boss protrudes from the mechanical component enclosure, and the structural boss is configured to contact the chip through the opening in the top plate.

Optionally, the foregoing structural boss may be in direct contact with the chip, or may be in indirect contact with the chip. Indirect contact represents that another medium may exist between the structural boss and the chip. For example, a thermal pad may be disposed between the structural boss and the chip, so that the structural boss may be in contact with the chip by using the thermal pad. Optionally, the thermal pad may be a conductive rubber, conductive silicone paper, or the like. This is not limited.

Optionally, the heat dissipation mechanical component may also be referred to as a metal heat dissipation mechanical component.

The electromagnetic shielding structure provided in this embodiment of this application includes the metal cover and the heat dissipation mechanical component. The metal cover and the heat dissipation mechanical component jointly cover the chip, to implement electromagnetic shielding for the chip. In addition, the structural boss of the heat dissipation mechanical component is in contact with the chip, so that heat generated by the chip can be conducted through the structural boss. This implements heat dissipation in the chip. Based on this, the electromagnetic shielding structure provided in this embodiment of this application can implement heat dissipation and electromagnetic shielding for the chip.

With reference to the first aspect, in some implementations of the first aspect, the structural boss is in contact with the chip by using the thermal pad.

In this embodiment of this application, the structural boss may be in contact with the chip by using the thermal pad. This may reduce a structural tolerance between the structural boss and the chip, to implement close combination between the structural boss and the chip. In addition, the heat generated by the chip may be conducted to the structural boss by using the thermal pad. This implements heat dissipation in the chip.

With reference to the first aspect, in some implementations of the first aspect, the mechanical component enclosure is in contact with the metal cover by using a conductive shielding material.

Optionally, the conductive shielding material may be any one or more of a metal spring plate, a metal dome, a conductive adhesive, a conductive foam, a conductive fabric, a copper foil, an aluminum foil, and the like.

In this embodiment of this application, the mechanical component enclosure may be in contact with the metal cover by using the conductive shielding material, so that the heat dissipation mechanical component can lap over the metal cover to form an enclosed electromagnetic shielding structure, thereby improving electromagnetic shielding effect.

With reference to the first aspect, in some implementations of the first aspect, the conductive shielding material includes a metal spring plate or a metal dome.

With reference to the first aspect, in some implementations of the first aspect, the metal spring plate or the metal dome is fastened to the mechanical component enclosure; or the metal spring plate or the metal dome is fastened to the top plate of the metal cover; or the metal spring plate or the metal dome forms an integrated structure with the mechanical component enclosure; or the metal spring plate or the metal dome forms an integrated structure with the top plate of the metal cover.

For example, the metal spring plate or the metal dome may be attached and fastened to the mechanical component enclosure or the top plate of the metal cover by using a conductive adhesive.

It should be understood that the metal spring plate or the metal dome forms an integrated structure with the mechanical component enclosure or forms an integrated structure with the top plate of the metal cover means that the metal spring plate or the metal dome is integrated with the mechanical component enclosure or is integrated with the top plate of the metal cover.

With reference to the first aspect, in some implementations of the first aspect, the heat dissipation mechanical component further includes a mechanical component separation rib, and the mechanical component separation rib is configured to surround the metal cover.

A downward extension height of the mechanical component separation rib is not limited in this embodiment of this application. Optionally, the mechanical component separation rib may only surround the top plate of the metal cover, or may surround a part of the side wall below the top plate, or may surround the entire metal cover.

In this embodiment of this application, the heat dissipation mechanical component may further include the mechanical component separation rib, to further prevent entrance of an electromagnetic wave and improve electromagnetic shielding effect.

With reference to the first aspect, in some implementations of the first aspect, the metal cover is fastened to the printed circuit board through soldering.

According to a second aspect, a chip structure is provided, including a chip and the electromagnetic shielding structure according to the first aspect or any one of the possible implementations of the first aspect.

According to a third aspect, an electronic device is provided, including the chip structure according to the second aspect and a printed circuit board, where the chip structure is fastened to the printed circuit board.

With reference to the third aspect, in some implementations of the third aspect, the electronic device is a head-up display (head-up display, HUD).

According to a fourth aspect, a vehicle is provided, including the electronic device according to the third aspect or any one of the possible implementations of the third aspect.

### BRIEF DESCRIPTION OF DRAWINGS

FIG. 1 is an example diagram of an electromagnetic shielding structure 100 according to an embodiment of this application;
FIG. 2 is an example diagram of a mechanical component enclosure according to an embodiment of this application;
FIG. 3 is an example diagram of an electromagnetic shielding structure 200 according to an embodiment of this application; and
FIG. 4 is an example diagram of an electromagnetic shielding structure 300 according to an embodiment of this application.

### DESCRIPTION OF EMBODIMENTS

The following describes technical solutions of embodiments in this application with reference to the accompanying drawings.

The solutions of this application may be applied to a chip structure related to fields such as autonomous driving, artificial intelligence, voice processing, and image processing. For example, a chip may include a universal flash storage (universal flash storage, UFS), a microcontroller unit (microcontroller unit, MCU), a clock driver, a central processing unit (central processing unit, CPU), an integrated access switch (integrated access switch, LSW), and the like.

In an example, the solutions of this application may be applied to a control chip related to a head-up display (head-up display, HUD) in a vehicle. In a possible implementation, the control chip is mainly configured to control a picture generation unit (picture generation unit, PGU) in the HUD to generate an image (for example, driving information such as a speed and navigation), so that the image is reflected to a driver's eye box by using a reflection component and a windshield. In this way, the driver can see a virtual image with a depth of field in a vehicle.

Optionally, the HUD may include a combiner-HUD (combiner-HUD, C-HUD) system, a windshield-HUD (windshield-HUD, W-HUD) system, an augmented reality HUD (augmented reality HUD, AR-HUD) system, and the like.

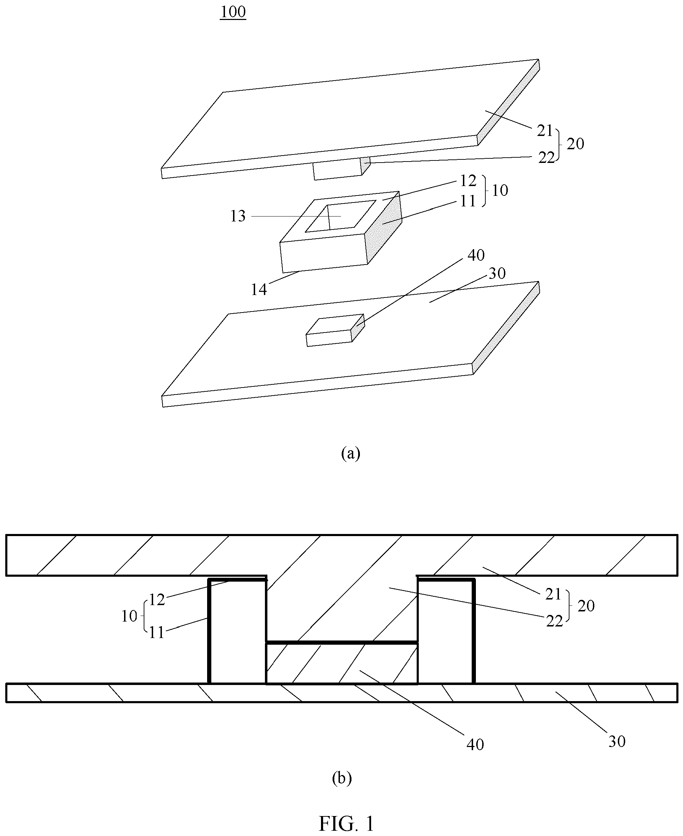

FIG. 1 is an example diagram of an electromagnetic shielding structure 100 according to an embodiment of this application. (a) in FIG. 1 is an example diagram of components included in the electromagnetic shielding structure 100. (b) in FIG. 1 is a side sectional example diagram of the assembled components shown in (a) in FIG. 1. It should be understood that the electromagnetic shielding structure 100 shown in FIG. 1 is only an example, and does not constitute a limitation on this application. In an actual operation, a shape and a size of each component may be determined based on an actual situation.

As shown in FIG. 1, the electromagnetic shielding structure 100 includes a metal cover 10 and a heat dissipation mechanical component 20. The metal cover 10 includes a side wall 11 and a top plate 12. The top plate 12 includes an opening 13. A bottom 14 of the side wall 11 is fastened to a printed circuit board 30, and the side wall 11 is configured to surround a chip 40 on the printed circuit board 30. The heat dissipation mechanical component 20 includes a mechanical component enclosure 21 and a structural boss 22. The structural boss 22 protrudes from the mechanical component enclosure 21. The structural boss 22 is configured to contact the chip 40 through the opening 13 in the top plate 12.

In a specific implementation, an assembly process of each component shown in (a) in FIG. 1 may be as follows: The metal cover 10 is fastened to the printed circuit board 30, so that the metal cover 10 surrounds the chip 40 on the printed circuit board 30; and the heat dissipation mechanical component 20 is pressed onto the chip 40 through the opening 13 in the top plate 12, so that the structural boss 22 of the heat dissipation mechanical component 20 is in contact with the chip 40 to dissipate heat for the chip 40, and the heat dissipation mechanical component 20 laps over the metal cover 10 to form the electromagnetic shielding structure shown in (b) in FIG. 1.

Optionally, the heat dissipation mechanical component 20 may also be referred to as a metal heat dissipation mechanical component.

The electromagnetic shielding structure 100 provided in this embodiment of this application includes the metal cover 10 and the heat dissipation mechanical component 20. The metal cover 10 and the heat dissipation mechanical component 20 jointly cover the chip 40, to implement electromagnetic shielding for the chip 40. In this case, the structural boss 22 of the heat dissipation mechanical component 20 is in contact with the chip 40, so that heat generated by the chip 40 can be conducted through the structural boss 22. This implements heat dissipation in the chip 40. Based on this, the electromagnetic shielding structure 100 provided in this embodiment of this application can implement heat dissipation and electromagnetic shielding for the chip 40.

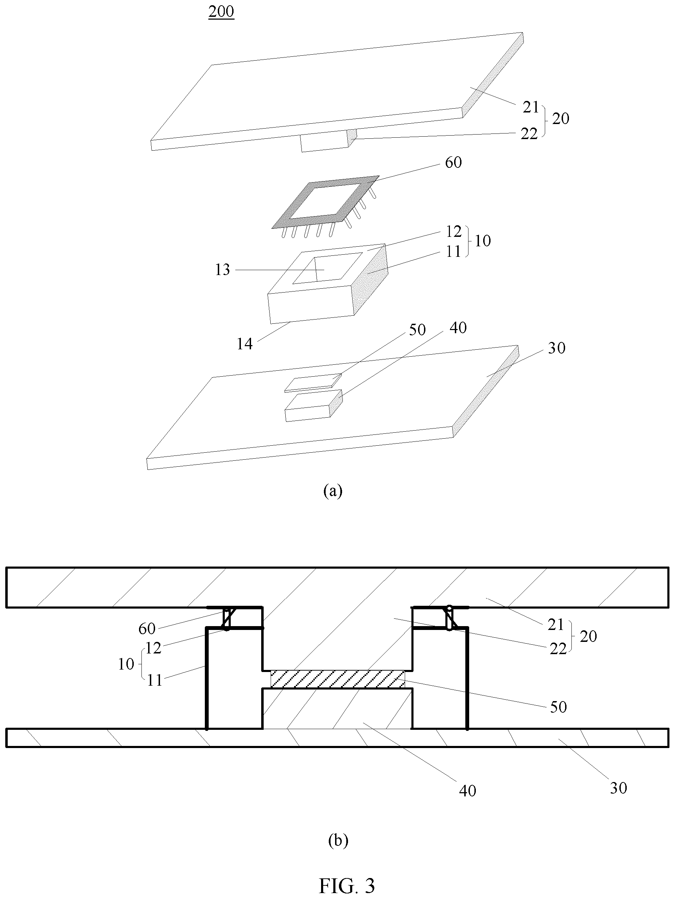

Optionally, the foregoing structural boss 22 may be in direct contact (as shown in (b) in FIG. 1), or in indirect contact (as shown in (b) in FIG. 3) with the chip 40. In a design, indirect contact may be implemented by disposing a thermal pad 50 between the structural boss 22 and the chip 40, so that the structural boss 22 may be in contact with the chip 40 by using the thermal pad 50. Optionally, the thermal pad 50 may be a conductive rubber, conductive silicone paper, or the like. This is not limited.

In this embodiment of this application, the structural boss 22 may be in contact with the chip 40 by using the thermal pad 50. This may reduce a structural tolerance between the structural boss 22 and the chip 40, to implement close combination between the structural boss 22 and the chip 40. In addition, heat generated by the chip 40 may be conducted to the structural boss 22 by using the thermal pad 50. This implements heat dissipation in the chip 40.

Optionally, the mechanical component enclosure 21 may be in contact with the metal cover 10.

In an implementation, the mechanical component enclosure 21 may be in contact with the metal cover 10 by using a conductive shielding material 60 (as shown in (b) in FIG. 3). Optionally, the conductive shielding material 60 may be any one or more of a metal spring plate, a metal dome, a conductive adhesive, a conductive foam, a conductive fabric, a copper foil, an aluminum foil, and the like. It should be understood that, in the accompanying drawing of this embodiment of this application, the conductive shielding material 60 is mainly described by using a structure of the metal spring plate as an example. However, it should be understood that in an actual operation, the structure of the conductive shielding material 60 is not limited thereto, and needs to be determined with reference to an actual situation.

In this embodiment of this application, the mechanical component enclosure 21 may be in contact with the metal cover 10 by using the conductive shielding material 60, so that the heat dissipation mechanical component 20 can lap over the metal cover 10 to form an enclosed electromagnetic shielding structure, thereby improving electromagnetic shielding effect.

The following uses a metal spring plate or a metal dome as an example to describe a position relationship between the metal spring plate or the metal dome, the mechanical component enclosure 21, and the metal cover 10.

Alternatively, the metal spring plate or the metal dome may be fastened to the mechanical component enclosure 21. Further, the metal spring plate or the metal dome may be attached and fastened to the mechanical component enclosure 21 by using the conductive adhesive.

Alternatively, the metal spring plate or the metal dome may be fastened to the top plate 12 of the metal cover 10. Further, the metal spring plate or the metal dome may be attached and fastened to the top plate 12 of the metal cover 10 by using the conductive adhesive.

Alternatively, the metal spring plate or the metal dome may form an integrated structure with the mechanical component enclosure 21. In other words, the metal spring plate or the metal dome may be integrated with the mechanical component enclosure 21.

Alternatively, the metal spring plate or the metal dome may form an integrated structure with the top plate 12 of the metal cover 10. In other words, the metal spring plate or the metal dome may be integrated with the top plate 12 of the metal cover 10.

In another implementation, the mechanical component enclosure 21 may alternatively be in direct contact with the metal cover 10 without using the conductive shielding material. This is not limited in this application.

Optionally, the mechanical component enclosure 21 may be not in contact with the metal cover 10. For example, there may be a slight distance between the mechanical component enclosure 21 and the metal cover 10 because of a structural tolerance or a process.

Specifically, the top plate 12 of the metal cover 10 may or may be not in contact with the structural boss 22. This is not limited in this application.

Optionally, the top plate 12 of the metal cover 10 may be fastened to the structural boss 22 in an assembly process (for example, a socket may be disposed on the structural boss 22, and a corresponding insert strip may be disposed on the top plate 12, so that the structural boss 22 and the top plate 12 can be connected and fastened in the assembly process).

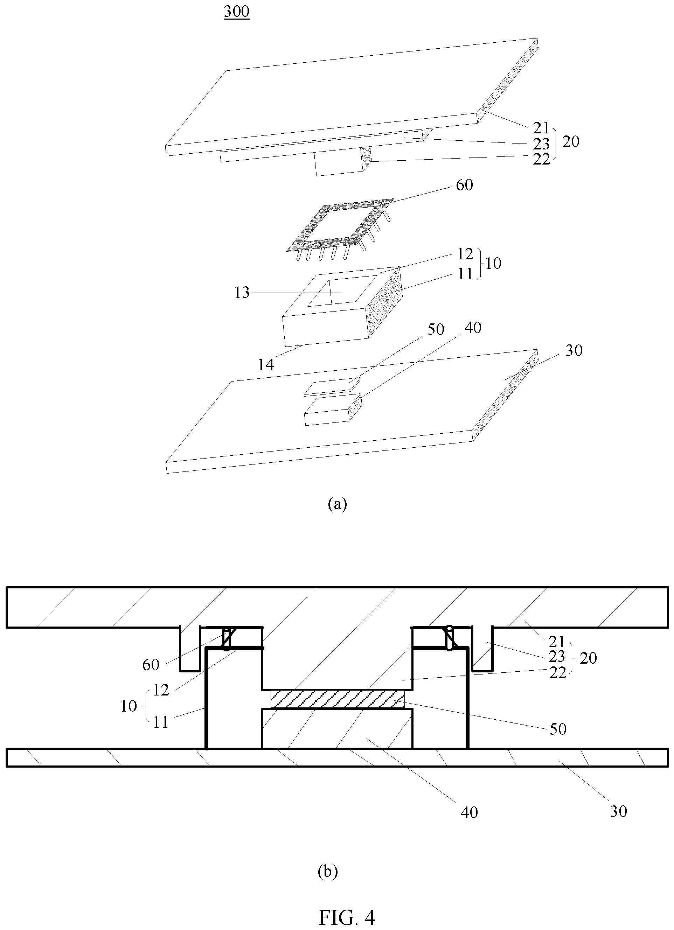

Further, the heat dissipation mechanical component 20 may further include a mechanical component separation rib 23. The mechanical component separation rib 23 is configured to surround the metal cover 10 (as shown in (b) in FIG. 4), to further prevent interference of an electromagnetic wave to a chip and improve electromagnetic shielding effect.

A downward extension height of the mechanical component separation rib 23 is not limited in this embodiment of this application. Optionally, the mechanical component separation rib 23 may only surround the top plate 12 of the metal cover 10, or may surround a part of the side wall 11 downward from the top plate 12, or may surround the entire metal cover 10.

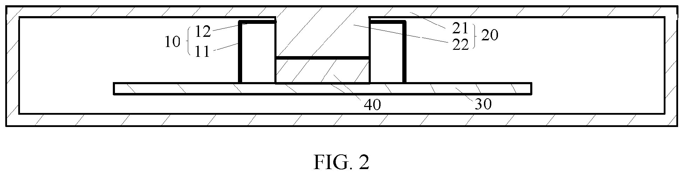

In a possible design, as shown in FIG. 2, an actual structure of the mechanical component enclosure 21 may be an enclosure configured to cover the printed circuit board 30. It means that the heat dissipation mechanical component 20 forms an integrated structure with the enclosure of the printed circuit board 30. In this design, when the electromagnetic shielding structure is used in a scenario in which a vehicle, an airplane, an uncrewed aerial vehicle, or the like frequently shakes, it can be ensured that the metal cover and the heat dissipation mechanical component in the assembled electromagnetic shielding structure are not disconnected under an external force.

Optionally, the metal cover 10 (that is, the bottom 14 of the side wall 11 of the metal cover 10) may be fastened to the printed circuit board 30 through soldering.

It should be understood that the thermal pad 50, the structural separation rib 23, and the conductive shielding material 60 may all exist, or only one or two of them may exist. As an example, the following uses FIG. 3 as an example to describe an electromagnetic shielding structure 200 in which both a thermal pad 50 and a conductive shielding material 60 exist; and uses FIG. 4 as an example to describe an electromagnetic shielding structure 300 in which a thermal pad 50, a conductive shielding material 60, and a structural separation rib 23 all exist.

FIG. 3 is an example diagram of an electromagnetic shielding structure 200 according to an embodiment of this application. (a) in FIG. 3 is an example diagram of components included in the electromagnetic shielding structure 200. (b) in FIG. 3 is a side sectional example diagram of the assembled components shown in (a) in FIG. 3. It should be understood that the electromagnetic shielding structure 200 shown in FIG. 3 is only an example, and does not constitute a limitation on this application. In an actual operation, a shape and a size of each component may be determined based on an actual situation.

As shown in FIG. 3, the electromagnetic shielding structure 200 includes a metal cover 10 and a heat dissipation mechanical component 20. The metal cover 10 includes a side wall 11 and a top plate 12. The top plate 12 includes an opening 13. A bottom 14 of the side wall 11 is fastened to a printed circuit board 30, and the side wall 11 is configured to surround a chip 40 on the printed circuit board 30. The heat dissipation mechanical component 20 includes a mechanical component enclosure 21 and a structural boss 22. The structural boss 22 protrudes from the mechanical component enclosure 21. The structural boss 22 is configured to contact a thermal pad 50 on the chip 40 through the opening 13 in the top plate 12. The mechanical component enclosure 21 is in contact with the metal cover 10 by using a conductive shielding material 60.

It should be understood that a possible assembly process of each component shown in (a) in FIG. 3 may be as follows: The metal cover 10 is fastened to the printed circuit board 30, so that the metal cover 10 surrounds the chip 40 on the printed circuit board 30; the thermal pad 50 is placed on the chip 40; and the heat dissipation mechanical component 20 is pressed onto the thermal pad 50 through the opening 13 in the top plate 12, so that the structural boss 22 of the heat dissipation mechanical component 20 is in contact with the thermal pad 50 to dissipate heat for the chip 40, and the mechanical component enclosure 21 is in contact with and laps over the metal cover 10 by using the conductive shielding material 60 to form the electromagnetic shielding structure shown in (b) in FIG. 3. It should be further understood that a sequence of performing the foregoing steps is not limited in this embodiment of this application.

It should be understood that for other information about the electromagnetic shielding structure 200, refer to the foregoing related description of the electromagnetic shielding structure 100. Details are not described again.

FIG. 4 is an example diagram of an electromagnetic shielding structure 300 according to an embodiment of this application. (a) in FIG. 4 is an example diagram of components included in the electromagnetic shielding structure 300. (b) in FIG. 4 is a side sectional example diagram of the assembled components shown in (a) in FIG. 4. It should be understood that the electromagnetic shielding structure 300 shown in FIG. 4 is only an example, and does not constitute a limitation on this application. In an actual operation, a shape and a size of each component may be determined based on an actual situation.

As shown in FIG. 4, the electromagnetic shielding structure 300 includes a metal cover 10 and a heat dissipation mechanical component 20. The metal cover 10 includes a side wall 11 and a top plate 12. The top plate 12 includes an opening 13. A bottom 14 of the side wall 11 is fastened to a printed circuit board 30, and the side wall 11 is configured to surround a chip 40 on the printed circuit board 30. The heat dissipation mechanical component 20 includes a mechanical component enclosure 21, a structural boss 22, and a mechanical component separation rib 23. The structural boss 22 protrudes from the mechanical component enclosure 21. The structural boss 22 is configured to contact, through the opening 13 in the top plate 12, a thermal pad 50 placed on the chip 40. The mechanical component enclosure 21 is in contact with the metal cover 10 by using a conductive shielding material 60. The mechanical component separation rib 23 is configured to surround the metal cover 10.

It should be understood that an assembly process of each component shown in (a) in FIG. 4 is as follows: The metal cover 10 is fastened to the printed circuit board 30, so that the metal cover 10 surrounds the chip 40 on the printed circuit board 30; the thermal pad 50 is placed on the chip 40; and the heat dissipation mechanical component 20 is pressed onto the thermal pad 50 through the opening 13 in the top plate 12, so that the structural boss 22 of the heat dissipation mechanical component 20 is in contact with the thermal pad 50 to dissipate heat for the chip 40, and the mechanical component enclosure 21 is in contact with and laps over the metal cover 10 by using the conductive shielding material 60 and the mechanical component separation rib 23 to form the electromagnetic shielding structure shown in (b) in FIG. 4. It should be further understood that a sequence of performing the foregoing steps is not limited in this embodiment of this application.

It should be understood that for other information about the electromagnetic shielding structure 300, refer to the foregoing related description of the electromagnetic shielding structure 100. Details are not described again.

An embodiment of this application further provides a chip structure, including a chip and the electromagnetic shielding structure according to any one of the foregoing possible implementations.

An embodiment of this application further provides an electronic device, including the foregoing chip structure and a printed circuit board. The chip structure is fastened to the printed circuit board.

Optionally, the electronic device may include, for example, any one of a desktop computer, a notebook computer, a smartphone, a tablet computer, a personal digital assistant (personal digital assistant, PDA), a wearable device, a smart speaker, a television, an uncrewed aerial vehicle, a vehicle, a vehicle-mounted apparatus (such as an in-vehicle infotainment system, a vehicle-mounted computer, or a vehicle-mounted HUD), or a robot.

An embodiment of this application further provides a vehicle, including the electronic device according to any one of the foregoing possible implementations.

The foregoing descriptions are only specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electromagnetic shielding structure, comprising:
a metal cover that comprises a side wall and a top plate, wherein the top plate comprises an opening, a bottom of the side wall is fastened to a printed circuit board, and the side wall is configured to surround a chip on the printed circuit board; and
a heat dissipation mechanical component that comprises a mechanical component enclosure and a structural boss, wherein the structural boss protrudes from the mechanical component enclosure, and the structural boss is configured to contact the chip through the opening in the top plate.

2. The electromagnetic shielding structure according to claim 1, wherein the structural boss is in contact with the chip by using a thermal pad.

3. The electromagnetic shielding structure according to claim 1 or 2, wherein the mechanical component enclosure is in contact with the metal cover by using a conductive shielding material.

4. The electromagnetic shielding structure according to claim 3, wherein the conductive shielding material comprises a metal spring plate or a metal dome.

5. The electromagnetic shielding structure according to claim 4, wherein
the metal spring plate or the metal dome is fastened to the mechanical component enclosure; or
the metal spring plate or the metal dome is fastened to the top plate of the metal cover; or the metal spring plate or the metal dome forms an integrated structure with the mechanical component enclosure; or
the metal spring plate or the metal dome forms an integrated structure with the top plate of the metal cover.

6. The electromagnetic shielding structure according to any one of claims 1 to 5, wherein the heat dissipation mechanical component further comprises:
a mechanical component separation rib, wherein the mechanical component separation rib is configured to surround the metal cover.

7. The electromagnetic shielding structure according to any one of claims 1 to 6, wherein the metal cover is fastened to the printed circuit board through soldering.

8. A chip structure, comprising a chip and the electromagnetic shielding structure according to any one of claims 1 to 7.

9. An electronic device, comprising the chip structure according to claim 8 and the printed circuit board, wherein the chip structure is fastened to the printed circuit board.

10. The electronic device according to claim 9, wherein the electronic device is a head-up display HUD.

11. A vehicle, comprising the electronic device according to claim 9 or 10.
